# EUROPEAN PATENT SPECIFICATION

(11) **EP 1 760 762 B1**
(45) Date of publication and mention of the grant of the patent: **01.02.2012**
(21) Application number: 05019361.4
(22) Date of filing: 06.09.2005
(51) Int. Cl.: H01J 37/30, H01J 37/05

(54) **Device and method for selecting an emission area of an emission pattern**
Vorrichtung und Verfahren zur Auswahl einer Emissionsfläche einer Emissionsstruktur
Dispositif et procédé pour la sélection d' une surface d' émission d'un motif d' émission

(43) Date of publication of application: 07.03.2007
(73) Proprietor: ICT Integrated Circuit Testing Gesellschaft für Halbleiterprüftechnik mbH, 85551 Heimstetten (DE)
(72) Inventor: Zhou, Fang, 85652 Pliening (DE); Frosien, Jürgen, 85521 Riemerling (DE)
(74) Representative: Zimmermann, Gerd Heinrich

(56) References cited:
- WO-A-01/26134
- US-A- 4 820 927
- US-A- 5 061 851
- US-A- 5 661 307
- US-B1- 6 465 783

## Description

### FIELD OF THE INVENTION

The present invention generally relates to a charged particle apparatus and more particularly to a charged particle apparatus and a method with charged particle emitters having a non-continuous emission pattern. More specifically, the present invention relates to a charged particle beam apparatus, a method for measuring an emission pattern and a method of selecting an emission peak of an emission pattern.

### BACKGROUND OF THE INVENTION

Charged particle beam apparatuses are used in a plurality of industrial fields, including, but not limited to, inspection of semiconductor devices during manufacturing, exposure systems for lithography, detecting devices and testing systems. There is a high demand for structuring, testing and inspecting specimens within the micrometer and nanometer scale. Micrometer and nanometer scale process control, inspection, or structuring, is often done with charged particle beams, e.g. electron beams. Charged particle beams offer superior spatial resolution compared to, e.g. photon beams due to their short wavelengths.

Besides resolution, throughput is an issue of such devices. Since large substrate areas have to be patterned or inspected, it is desirable that the throughput is, for example larger than 10 cm²/min. In charged particle beam device, the throughput depends on the charged particle beam current. Thus, there is a need for increasing the beam current. Generally, for the following discussion, there is no need for distinguishing between secondary electrons, backscattered electrons and Auger electrons. Therefore, the three types together, for simplicity, will be referred to as "secondary electrons".

In view of the desire for increased charged particle beam currents, charged particle beam emitters such as field emission emitters have an enormous potential due to their high brightness. Further, these emitters have a small source size and low energy spread. A (cold) field emitter typically includes a crystal of tungsten formed to a very narrow point which is mounted to a loop of a tungsten wire. The very narrow point is also frequently referred to as an emitter tip. When applying a voltage to the cold field emitter, a very high electric field is formed at the emitter tip due to its small radius of curvature. The high electric field enables the electrons to pass the potential barrier between the metal and the vacuum in which the cold field emitter is placed. Accordingly, the established electric field is often referred to as an electric extractor field as it causes the electrons to be "extracted" from the emitter tip.

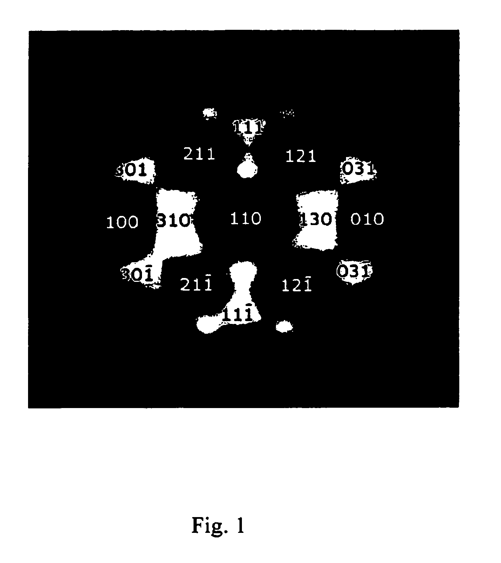

Generally, crystalline field emitters have different emission areas corresponding to different crystal surfaces or orientations on the small tip. The beam current and the emission stability of a field emission gun can depend strongly on the emission area of the field emitter. Figure 1 shows a typical emission pattern of a <110> oriented single crystalline tungsten emitter obtained by using field electron microscope (FEM). The brightness of different emission areas is highly different because of the different work functions for the different crystal surfaces. In addition, the stability of the emission current differs depending on the emission corresponding to a crystal orientation. To enhance the brightness of a field emitter an additional coverage may be applied in order to reduce the work function of certain crystal surfaces, for example W(100)-ZnO Schottky emitter.

Prior art devices tend to determine the emission area by a rough mechanical alignment of the position and the crystal orientation.

In US 4 820 927 is disclosed an electron beam source wherein the size and shape of the emitting area of the cathode are selectable over a wide range, either by means of illuminating the cathode selectively or by masking the emitting window.

In practice it is desired to optimize the brightness and the stability of the charged particle beam current, especially in the case of cold field emission.

### SUMMARY OF THE INVENTION

In view of the above a charged particle beam apparatus is provided. The apparatus includes: an emitter (102) with an emission pattern including at least two emission peaks; a gun lens (119 ; 519 ; 919); and a diaphragm (120); wherein the gun lens includes a deflector unit (110); and wherein the deflector unit is adapted to direct an emission peak of the at least two emission peaks to an opening of the diaphragm to thereby select the emission peak of the emission peaks from the at least two emission pattern.

Further, the charged particle beam apparatus can be provided, wherein the gun lens and the deflector unit are positioned within a distance of about 50 mm or less from the emitter.

Further a method for measuring an emission pattern of an emitter is provided. The method includes the steps of: providing an emitter (102) with an emission pattern including at least two emission peaks; deflecting the emission pattern of the charged particle beam over an opening of a diaphragm (120); focusing the charged particle beam with a gun lens, the gun lens comprising a deflector unit adapted to direct an emission peak of the at least two emission peaks to the opening of the diaphragm, thereby selecting the emission peak of the least two emission peaks from the emission pattern; measuring a value correlated to the current passing through the diaphragm; and evaluating the value as a function of the deflection.

Further, a method of selecting an emission peak of an emission pattern is provided. The method includes the steps of: providing an emission pattern obtained according to any of claims 25 to 30; electing an emission peak of the emission pattern; and deflecting the charged particle beam to allow the elected emission peak to pass through an opening of a diaphragm (120).

Further advantages, features, aspects and details are evident from the dependent claims, the description and the drawings.

According to another aspect a charged particle beam apparatus is provided. The apparatus includes an emitter with none-regular or non-continuous emission pattern; a gun lens; a deflector unit; and a diaphragm; wherein the deflector unit is integrated in the gun lens; and wherein the deflector unit is adapted to direct a part of the emission pattern to an opening of the diaphragm to thereby select the emission of an emission area of the emitter.

According to another aspect a charged particle beam apparatus is provided. The apparatus includes an emitter with none-regular or non-continuous emission pattern having emission peaks, e.g. a field emitter; a gun lens; and a diaphragm; wherein the gun lens includes a deflector unit; and wherein the deflector unit is adapted to direct an emission peak of the emission peaks to an opening of the diaphragm to thereby select the emission peak of the emission peaks from the at least two emission patterns.

According to an even further aspect the deflector unit and/or the gun lens is positioned within a distance of about 50 mm or less from the emitter, for example typically within about 30 mm or less from the emitter. Thereby, the position of the gun lens is defined by the middle electrode.

According to yet another aspect a charged particle beam apparatus is provided, the apparatus includes: an emitter with an emission pattern including at least two emission peaks; a gun lens; a deflector unit; and a diaphragm; wherein the gun lens and the deflector unit are positioned within a distance of about 50 mm or less from the emitter, for example typically within a distance of about 30 mm or less from the emitter..

According to another aspect a method for measuring an emission pattern of an emitter is provided. The steps are as follows: providing an emitter with a non-regular or non-continuous emission pattern; deflecting the emission pattern of the charged particle beam over an opening of a diaphragm; measuring a value correlated to the current of the charged particle beam passing through the diaphragm; and evaluating the value as a function of the amount of deflection.

According to yet a further aspect a method of selecting an emission peak of an emission pattern is provided. The method includes the steps of: providing or measuring an emission pattern of an emitter with a non-regular or non-continuous emission pattern; electing an emission peak of the emission pattern; and deflecting the charged particle beam to allow the elected emission peak to pass through an opening of a diaphragm.

Aspects are also directed to apparatuses for carrying out the disclosed methods and including apparatus parts for performing each described method steps. These method steps may be performed by way of hardware components, a computer programmed with appropriate software, or by any combination of the above two or in any other manner. Furthermore, aspects are also directed to methods by which the described apparatus operates. It includes method steps for carrying out every function of the apparatus or manufacturing every part of the apparatus.

### BRIEF DESCRIPTION OF THE DRAWINGS

Some of the above indicated and other more detailed aspects of the invention will be described in the following description and partially illustrated with reference to the figures. Therein:
- Fig. 1: shows a typical emission pattern of a field emission tip, wherein the brightness of different crystal surfaces, which are marked with indices, are different;
- Fig. 2: shows a first embodiment of a gun region of a charged particle beam device according to the present invention;
- Fig. 3: shows a schematic drawing of a charged particle beam device according to the present invention;
- Fig. 4a: to 4c show embodiments of deflector units to be positioned in the gun region according to the present invention;
- Fig. 5: shows a schematic drawing of an embodiment of a gun region according to the present invention, wherein a deflector unit and an electrode with a diaphragm is integrated in the gun lens;
- Fig. 6: shows a schematic drawing of an embodiment of a gun region according to the present invention, wherein a deflector unit and an electrode with a diaphragm is integrated in the gun lens and a double deflector for beam alignment is provided;
- Fig. 7: shows a schematic drawing of an embodiment of a gun region according to the present invention, wherein a deflector unit and an electrode with a diaphragm is integrated in the gun lens and a displacement unit for the emitter is provided;
- Fig. 8: shows a schematic drawing of an embodiment of a gun region according to the present invention, wherein a deflector unit and an extractor is integrated in the gun lens and wherein a double deflector for beam alignment and a displacement unit for the emitter is provided; and
- Fig. 9: shows a schematic drawing of an embodiment of a gun region according to the present invention, wherein a deflector unit is integrated in the gun lens.

### DESCRIPTION OF THE PREFERRED EMBODIMENTS

Reference will now be made in detail to various embodiments, examples of which are illustrated in the drawings. In the Figures and the description that follows, like reference numerals refer to similar elements. The example is provided by way of explanation, and is not meant as a limitation of the invention. For example, features illustrated or described as part of one embodiment can be used on or in conjunction with other embodiments to yield yet a further embodiment. It is intended that the present invention includes such modifications and variations.

In particular, the following embodiments will be described with reference to electron beams and field emitters, specifically cold field emitters. This is not to be understood as a limitation to the invention. The invention can also be applied to other charged particles and other types of emitters with non-continuous emission patterns. For example, nanotubes and other functional materials which have extremely high brightness but no continuous emission pattern may also be used for the present invention. Further, instead of electrons as charged particles, the present invention may also be used for ions and respective ion emitters having an emission pattern with different distinct emission areas.

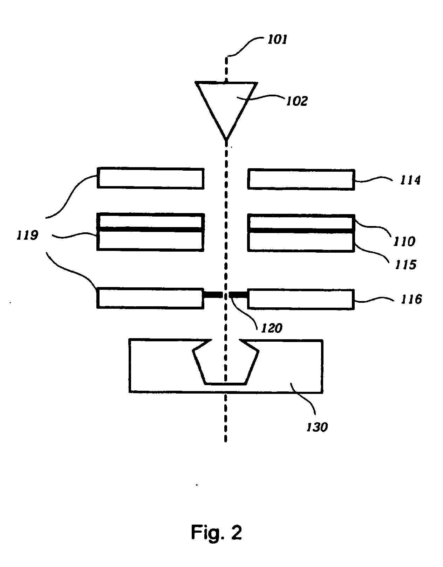

The first embodiment will now be described with respect to figure 2. Figure 2 shows a field emitter 102 that is essentially located on optical axis 101. The field emitter 102 has an emission characteristic comparable to the pattern shown in figure 1. The emission of emitter 102 is based on a potential difference between the emitter and the extractor 114, as well as the very small radius of the emission tip, resulting in high electric fields capable of extracting electrons from the emission tip of the emitter 102.

In order to select the emission of one emission area of the emission pattern of the emitter 102, a deflector unit 110 is provided. The deflector unit 110 is a multipole element, which may be electrostatic, magnetic or combined magnetic-electrostatic. The deflector 110 is close to the emitter 102. This is to be understood so that the deflector unit may be positioned within a distance of 25 mm or less to the emitter tip, preferably within a distance of 20 mm or less. Therefore, the deflector will be placed in the same ultrahigh vacuum (UHV), which is required for the field emitter and is in the range of about 1*10-8 mbar (0.75*10-8 Torr) or less. In order to obtain a reasonably stable emission from a field emitter, an ultra high vacuum is required which is typically better than 1.33*10-7 Pa (10-9 Torr) and in particular better than 1.33*10-9 Pa (10-11 Torr). Principally, the lower the pressure the better the vacuum. Because of these vacuum conditions in which the deflector unit is placed, typically but not limited to the specific embodiment, the deflector unit 110 is preferred to be an electrostatic multipole element.

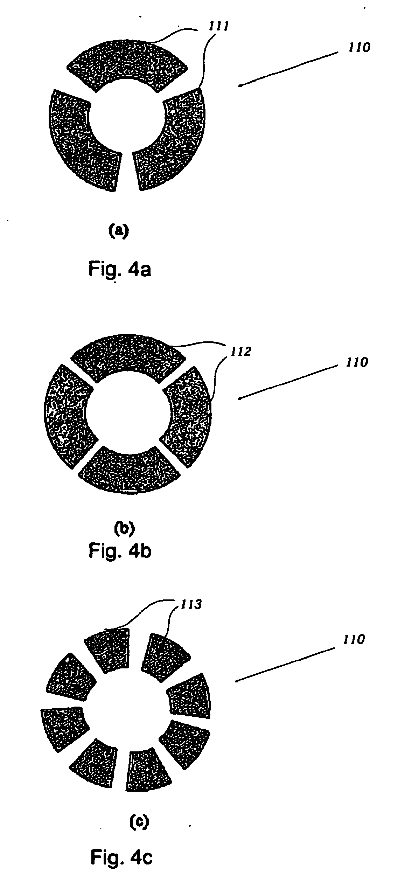

The multipole element includes at least three electrodes and is typically provided in the form of a quadrupole with four electrodes. Also an octupole with eight electrodes may be used, as described in respect to figures 4a to 4c.

The multipole elements enable the deflector to scan the electron beams two-dimensionally in a plane perpendicular to the optical axis 101. Thereby, the emission areas of the emission pattern of the emitter 102, for example a cold field emitter, can be scanned over the diaphragm 120, which is integrated into electrode 116. By scanning the emission areas over the diaphragm 120, which forms a small aperture stop, one of the different emission areas of the emission pattern can flexibly be selected. The diaphragm or aperture has an opening with a diameter of e.g. about 1 µm to 50 µm.

The different emission areas are irregular but each provide high coherent monoatomic field emission. Each of these emission spots, which can be seen illustratively in figure 1, has a specific characteristic. Some of them provide a very high brightness, that is a high beam current, a very good stability of the beam current, or an advantageous beam shape. Being able to flexibly select one of the emitted spots corresponding to a specific emission area of the emitter allows to select the individual electron beam as required for a specific application. Generally, an emission area with high brightness and high stability may typically be chosen.

The components 114, 115 and 116 form a gun lens 119, which may typically be used as a condenser lens. Thereby, the arrangement of three electrodes may be applied as an Einzel-lens or as an immersion lens. The different types of lenses may also be used for other embodiments described with respect to the other figures.

In the embodiment shown in figure 2, the extractor 114, the deflector unit 110 and the electrode 116, which includes the diaphragm 120, are integrated in the gun lens 119. For all embodiments shown with respect to figures 2 to 9, the gun lens includes the deflector unit and the other components. These components are integrated in the gunlens. According to a typical option, the deflector unit and partially the other components may form an electrode of the gun lens. Thereby, these components would be integrated as well but would, however, additionally replace a component of the gun lens.

In view of the above, the gun lens and that deflector unit 110 can be located close to the field emitter 102. Typically, and independent of specific embodiments described herein, the gun/condenser lens and the deflector unit may be positioned within a distance of 25 mm or less to the emitter tip, preferably within a distance of 20 mm or less.

The following two advantages can be achieved by placing the gun lens 119 and that deflector unit 110 close to the emitter. First, high current applications suffer from electron-electron-interaction in the primary electron beam. The electron-electron-interaction increases the energy width of a charged particle beam and, thereby, chromatic aberrations. Further, stochastic scattering between electrons blurs the electron beam. Thus, it can be considered advantageous to block parts of the emitted electrons as close to the emitter as possible. This reduces the electron-electron-interaction along the rest of the electron beam path.

Second, charged particle sources, like cold field emitters, which have a very small tip, or other arrangements with sources also having a small virtual size, such as CFE SEMs or FIBs typically use a small demagnification of the electron beam scanned over a specimen. Therefore, telecentric arrangements with Mag 1:1, or Mag < 10, are widespread for applications with sources having a small virtual size. These arrangements often, but not necessarily avoid cross-overs, e.g. after the gun lens. Avoiding cross-overs can reduce electron-electron-interactions. As an example, there will be no crossover after the emitter tip until the charged particle beam is focused on the specimen. In the event of a small demagnification, the aberrations introduced by the condenser lens have increasing influence. Consequently, these aberrations are intended to be reduced by a small focal length of the condenser lens. This can be realized by the above-mentioned position close to the emitter 102.

The present invention further enables to precisely localize the emission areas suitable for the respective needs that are, generally, high brightness and high stability. Additionally, the alignment of the electron beam of the system is simplified. Further, different emission spots with different brightness can be chosen. Thereby, the beam current can be varied for different applications. As a result, other arrangements like multiple aperture plates or the like can be omitted. A further advantage is that inexpensive polycrystalline field emitters may be utilized. For example, a field emission tip etched from a polycrystalline tungsten wire delivers in most cases an emission pattern similar to the pattern shown in figure 1. As already mentioned above, emission from nanotubes and of functional materials which have extremely high brightness but no continuous emission pattern can also be used with the present invention.

Returning now to the embodiment of figure 2. Below the diaphragm 120, a detector 130 is shown. In this embodiment a Faraday-cup like detector is used after the small aperture. The Faraday-cup detects the amount of electrons passing through the small aperture. The Faraday-cup can be moved into the beam path that is on the optical axis to conduct the following method.

An emission pattern of the field emitter is projected on the plane of the aperture 120. Thereby, the deflector unit scans (sequentially) the entire pattern through the aperture, that is the diaphragm. Detector 130 measures the charge or the current, respectively. Using the scan signal and the measured current an image of the emission pattern is obtained. Thereby, it is further possible to use the gun lens to change the resolution and/or the magnification of the measured pattern. The measured pattern can be evaluated with respect to the desired needs such as brightness, stability or the like. The deflector unit 110 can be used to select certain emission areas when the charged particle beam apparatus is operated under normal conditions for testing purposes, inspection purposes or other applications.

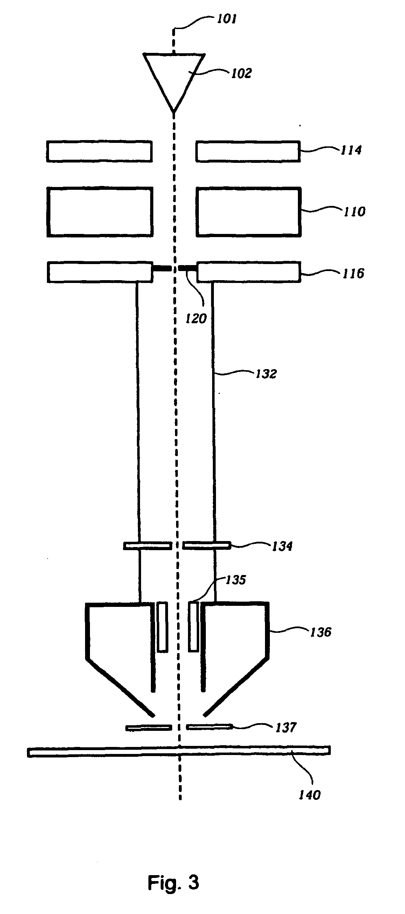

Instead of the Faraday-cup type detector, which directly detects the amount of electrons which pass through the diaphragm, other detectors may be utilized. For example, the amount of electrons may also be measured indirectly. An example for an indirect measurement of the current passing through the diaphragm will now be described while referring to figure 3.

Similarly to figure 2, the embodiment of figure 3 shows an emitter 102, an extractor 114, a deflector unit 110 and an electrode 116 with an aperture/diaphragm 120. The extractor, the deflector unit and the electrode form a gun lens. Further, figure 3 shows a tube 132, which is used to accelerate the electrons to a high potential. This beam boost reduces electron-electron-interaction. If the electrons are already accelerated, e.g. by a gun lens being an immersion lens, tube 132 keeps the electrons on the high potential.

The charged particle beam is focused on specimen 140 by an objective lens. As an example, the objective lens is shown as a combined magnetic-electrostatic lens, including a magnetic part 136 and an electrostatic part that is formed by the retarding electrode 137 and the above-mentioned high potential provided by tube 132. However, it is to be understood that other lenses can also be used. It is also possible to use electrostatic lenses, which may typically be Einzel-lenses or immersion lenses. Furthermore, magnetic lenses or other types of combined magnetic-electrostatic lenses may be used.

Figure 3 also shows a scan deflector 135, which is used to scan the electron beam over the specimen. Scan deflectors 135 may include scan coils for magnetic deflection of the electron beam. Due to impingement of the part of the emitted electrons that have passed through the diaphragm 120 on the specimen 140, secondary electrons or other particles such as backscattered electrons, Auger electrons, photons or X-rays are released. The electrons are accelerated through the objective lens by electrode 137 and are detected by detector 134.

In the event no objective lens would be provided and the gun lens would be used to focus the primary charged particle beam on the specimen 140, the deflector 135 and the detector 134 are positioned between the diaphragm and the specimen.

Referring to the above-mentioned measurement of the amount of electrons which pass through the diaphragm, the amount of detected secondary electrons can be used as an indirect indicator for the current passing through diaphragm 120. Therefore, the above described method can be modified as follows. The deflector unit 110 is used to scan the emission pattern of the emitter 102 over the aperture 120. While the part of the electrons passing through the aperture generates secondary electrons on impingement on the specimen 140, the secondary electrons are detected by detector 134. The scan signal of the deflector unit 110 and the signal detected by detector 134 are used to generate an image of the emission pattern.

Generally, the examples described above, can be described as follows. The following methods can be applied with the present invention. The charged particle beam is emitted by emitter 102, typically a field emitter or another emitter (nanotubes or the like) with non-continuous emission patterns. A deflector unit is operated to scan the emitted charged particles over the diaphragm. The diaphragm has a size to let a part of the charged particle beam pass through the opening therein and to block another part of the charged particle beam. Optionally, the gun lens can be used to change the resolution and/or the magnification of the charged particle beam scanned over the diaphragm. In a further step, the current or the amount of charge, respectively, passing through the diaphragm is measured. This may be realized with a detector subsequent to the diaphragm, which measures the charged particle beam directly, or with an in direct measurement such as the detection of secondary particles released on impingement of the charged particle beam to be measured. An image of the emission pattern can be obtained by evaluating the amount of particles, which has passed through the diaphragm, as a function of the amount of deflection introduced by the deflector unit 110. To determine the amount of deflection, typically the scan signal for the deflector unit may be utilized.

With the obtained emission pattern, a method for operating the charged particle beam apparatus with the following steps may further be conducted. The charged particle beam is emitted by emitter 102, typically a field emitter or another emitter with non-continuous emission patterns. A part of the charged particle beam is selected by controlling the deflector unit 110 such that desired charged particles pass through the diaphragm. The charged particles of the selected emission area is focused and/or scanned over a specimen to be tested or inspected. Secondary and/or backscattered charged particles, photons or X-rays are detected by a detector in order to obtain a measurement result from the specimen to be tested or inspected. It is to be understood that this method may not only be applied for methods imaging a specimen but also for lithography methods and lithography apparatuses, which use the charged particle beam to pattern a mask, a substrate or the like. A focused ion beam device (FIB) would be an example for a system using an ion emitter.

Depending on the desired application, the emitter may either be an electron emitter or an ion emitter. There are also different types of ion emitters which have a non-continuous emitter pattern and for which apparatuses and methods according to the present invention can be used. Generally, the present invention relates to those devices and methods with emitters having a non-continuous emission pattern. Thereby, non-continuous is to be understood as having a plurality of distinct emission areas, e.g. crystallographic surfaces, whereby a distinct emission can be assigned to a distinct emission area. The different emission areas form an emission pattern. According to the invention a part of the charged particle emission from the whole emission pattern is selected. The other parts of the charged particle beam are blocked.

A non-continuous emission pattern means not the common "bell-shaped" emission distribution starting from the emitter tip. Instead emitters having an emission pattern starting from its tip region, which shows at least two emission peaks in their emission characteristics, are meant. At least two peaks mean that in the 3-dimensional emission characteristic irradiating from the tip region (in which the field strength is highest) at least two directions can be found, which have a direction of less emission current density between those two directions. There are at least two local maxima in emission. Thus, generally, the non-continuance emission pattern can also be regarded as intermittent or sporadic.

Figures 4a to 4c show embodiments of deflector units 110. Figure 4a shows an embodiment including a multipole element with three segments 111. The three segments enable the deflector unit to deflect the electron beam two-dimensionally in a plane essentially perpendicular to the optical axis 101 (see figure 3). Thereby, a two-dimensional image of the emission pattern can be generated.

The segments may either be electrostatic, magnetic or combined magnetic-electrostatic. In view of the fact that the deflector unit including the segments is typically positioned close to the emitter, the deflector unit needs to be within UHV. Therefore, it can be considered advantageous in this case if the multipole element is electrostatic.

According to another embodiment, shown in figure 4b, the deflector unit 110 includes a multipole element with four segments 112. Again, the multipole element can either be electrostatic, magnetic or combined magnetic-electrostatic. This quadrupole element is also capable of deflecting the emitted electron beam in two directions (x-y-plane, when z-axis denoted as optical axis) over the diaphragm. Figure 4c shows a further embodiment with an octupole as a multiple element. The octupole includes eight segments 113, each segment of the multipole element may be electrostatic, magnetic or combined magnetic-electrostatic.

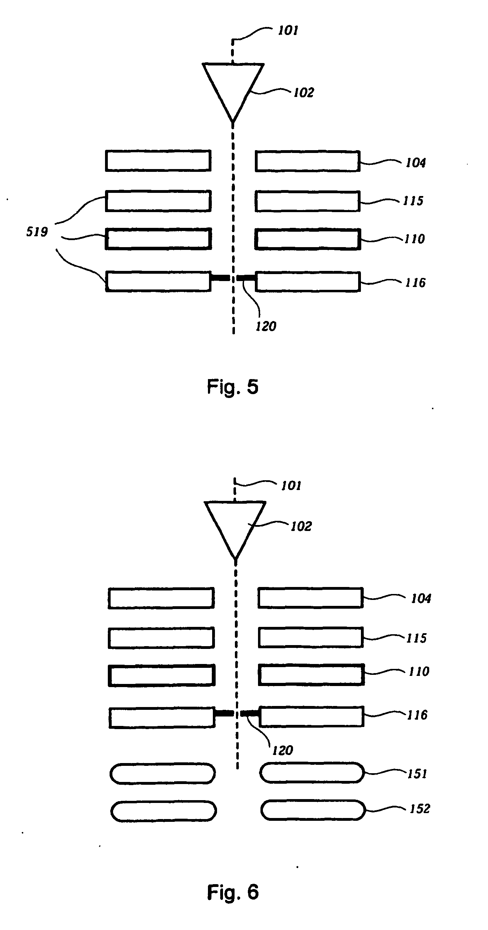

Figure 5 shows a further arrangement according to the present invention. Emitter 102 is positioned essentially on optical axis 101. The emitter, which may typically be a field emitter, emits electrons by the combined action with extractor 104. When applying a voltage to the cold field emitter, a very high electric field is formed at the emitter tip due to its small curvature. The high electric field enables the electrons to pass the potential barrier between the metal and the vacuum in which the cold field emitter is placed. Accordingly, the established electric field is often referred to as electric extractor field as it causes the electrons to be "extracted" from the emitter tip. Thereby, it is possible to provide the field emitter 102 and the extractor 104 as one pre-assembled or combined package.

A gun lens 519 is provided by components 115, 110 and 116. In this embodiment, electrode 115, deflector unit 110 and electrode 116 form an Einzel-lens. The deflector unit 110 is integrated in the gun lens 110 and is capable of scanning the emission pattern of emitter 102 over diaphragm 120. With this arrangement it is also possible to have the gun lens and the deflector unit close to the emitter. Thereby, on the one hand, a gun lens acting as a condenser lens can be provided with a short focal length. On the other hand, the deflection and selection of parts of the electron beam can also be realized close to the emitter. Thereby, the beam current within the rest of the column is reduced. Thus, negative influences from electron-electron-interactions can also be reduced.

In order to select the desired area of the emission pattern, the beam is deflected by deflector unit 110 such that the desired area of the emission pattern passes through diaphragm 120. However, the beam may therefore be deflected unsuitable with respect to the optical axis 101. The embodiment shown in figure 6, therefore, further includes a double deflector with deflectors 151 and 152. The deflectors may be used to align the part of the electron beam passing through diaphragm 120 with respect to the optical axis. The deflectors 151 and 152 may either be electrostatic, magnetic or combined magnetic-electrostatic. The alignment of the electronic beam can be realized by controlling the first deflector 151 such that the electron beam is directed onto the optical axis within the second deflector 152. The second deflector is then used to change the direction of the electron beam along the optical axis. Generally, since the deflection action away from the optical axis, which is introduced by deflector unit 110, may be two-dimensional in a plane perpendicular to the optical axis, the double deflector unit 151,152 should also typically be capable of deflecting the electron beam in two directions perpendicular to the optical axis. Whether or not the deflection takes place in one or two directions depends on the area of the emission pattern that has been selected to pass through diaphragm 120.

For emisssion sources like CFE, which e.g. emit in different directions, it is intended to image the tip and select the approriate part of the emisssion. According to the present invention, a part of the emitted charged particle corresponding to an emission area is selected by deflecting the emission pattern of the field emitter over a diaphragm. Thereby, it would be preferred if the pivot-point would be at the position of the emitter. Therefore, either a deflector would be required within the emitter or a two-stage deflector would be required directly after the emitter and before the gun/condenser lens. The first option cannot be realized and the second option would increase the distance of the condenser lens from the emitter. As a consequence, the focal length and thus, the aberration of the condenser lens would increase. In view of the above, according to the present invention, the deflector unit for scanning the emission pattern over the diaphragm may be integrated into gun lens or a single-stage deflector may be positioned between the emitter and the gun lens.

The term integrated is to be understood such that the gun lens comprises the deflector unit. That is, the deflector unit is provided as an additional electrode within the gun lens, or the deflector forms a part of the gun lens, preferably, e.g., the middle electrode. In the latter case a component of the gun lens is replaced by the deflector unit.

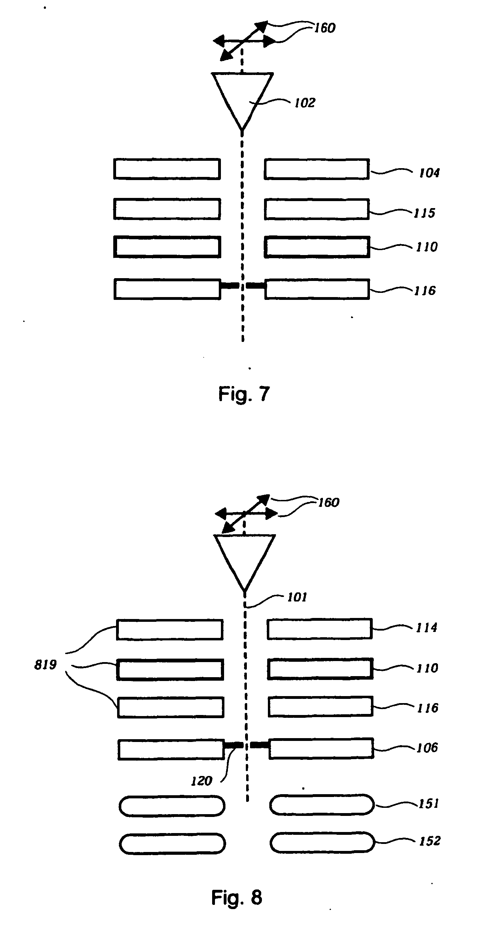

In the embodiment of figure 6, the middle electrode of a conventional gun lens is replaced by a multipole element which forms the deflector unit. The multipole element may for example be electrostatic. In order to compensate for misalignments with respect to the optical axis introduced by selecting the desired part of the electron beam, a further deflection system is included after the diaphragm. In a further embodiment, shown in figure 7, the shift of the electron beam introduced by deflector unit 110 is further combined with the shift of the electron beam introduced by a mechanical displacement of the emission tip. The displacement unit 160 enables the emitter 102 to be moved, preferably in two directions perpendicular to the optical axis. The combined action of the mechanical shift of the emitter and the deflection of the electron beam improves the capability of selecting a certain emission area of the emission pattern precisely.

According to a further embodiment, shown in Fig. 8, the displacement unit 164 shifting the emission tip, the deflector unit and the double deflector 151, 152 may be combined. This enables a precise selection of the desired emission area of the emission pattern by the combined mechanical shift of the emission tip and an electrical shift of the deflector unit, as well as a beam alignment to the optical axis 101 after the aperture 120. Within Fig. 8, further the gun lens is constituted by components 114, 110 and 116. Electrode 106 including diaphragm 120 is positioned (immediately) after the gun lens.

The mechanical shift, the electrical shift and/or the aligment after the diaphragm are used to have a selected part of the emission pattern raster-scanned essentially straight and essentially on the optical axis, that is through the center of the lens, through the diaphragm.

The apertures/diaphragms 120 of the above mentioned embodiments typically have a circular shape. However, if desired for the individual application, also slit-shaped diaphragms may be used. The diameter of circular apertures may be in the range of about 1 µm to about 100 µm, preferably in the range of about 5 µm to about 50 µm. In the event that slit shaped apertures are used, the width of the slit may be in the range of about 1 µm to about 100 µm, preferably in the range of about 5 µm to about 50 µm. The length of the slit can be up to several millimeters, e.g. 2 mm.

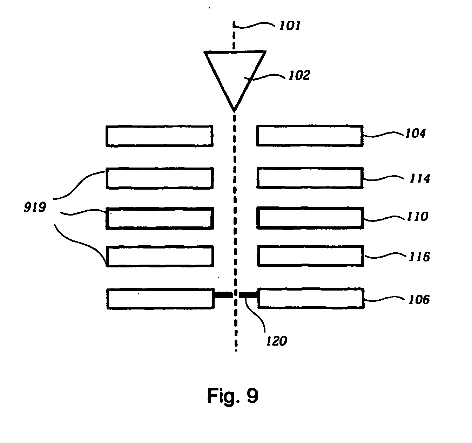

Within the embodiments described with respect to figures 2 to 8, the gun lens, which typically constituted a condenser lens, includes the deflector unit 110 or the deflector is a part of the gun lens. Further, within some of these embodiments an electrode 116 including the diaphragm 120 was also incorporated in the gun lens. The same applies for extractor 114 which was incorporated in the gun lens in some embodiments. Both, electrode 106 and extractor 104 have also been shown as not being a part of the gun lens. Figure 9 shows an embodiment wherein extractor 104 and electrode 106 are separated from the gun lens 919. Gun lens 119 includes electrodes 114 and 116 as well as deflector unit 110. Thereby, electrode 114 can be used as a second extractor (anode) for the field emitter 102.

According to a further embodiment (not shown) the deflector unit 110 may also be positioned above the gun lens. Thus, the deflector 110 is positioned between the gun lens and the emitter.

For the embodiments of the present application, high precision lenses, as e.g. disclosed in EP 1530229, can also be used. Therein, the lenses are disclosed to have a first element having a first opening for acting on said charged particle beam; at least a second element for acting on said charged particle beam; at least one distance piece positioned between said first element and said at least second element to provide for a minimum distance between said first element and said second element; and a first holding piece for abutting said first element to said at least one distance piece, whereby said first holding piece is attached to said at least one distance piece. The distance and holding pieces allow for a high precision alignment of a first electrode or pole piece with respect to a second electrode or pole piece.

Individual embodiments of the present invention may further include individual features or feature combinations of the following details. The deflector unit may be positioned between the emitter and the gun lens. The deflector unit may also be integrated in the gun lens, wherein the deflector unit is adapted to direct an emission peak of the at least two emission peaks to an opening of the diaphragm to thereby select the emission peak of the at least two emission peaks from the emission pattern. The deflector unit may be positioned within a distance of about 30 mm or less from the emitter. The deflector may be a field emitter. The diaphragm may be positioned after the deflector unit and may be adapted to have the plurality of emission areas to be scanned over the opening of the diaphragm by the deflector unit. The diaphragm may be integrated in the last electrode of the gun lens. The charged particle beam device may include an extractor for extracting the charged particles from the emitter. The extractor may be integrated in the gun lens and may additionally be adapted to form the first electrode of the gun lens. The deflector units can include a multipole element either with at least three segments, or being a quadrupole element or an octupole element. The multipole element may be integrated in the gun lens and may additionally be adapted to form the middle electrode of the gun lens. The deflector unit may be electrostatic, whereas, independent therefrom, the gun lens may be electrostatic, magnetic, or combined electrostatic-magnetic. The devices may further include a displacement unit for mechanically shifting the emitter in a plane essentially orthogonal to the optical axis and/or a detector for measuring the charged particle current passing through the diaphragm. The detector may be a faraday-cup positioned after the diaphragm. Alternatively or additionally, a detector measuring secondary electrons released from a specimen on impingement of the charged particles emitted by the emitter may be provided. Further a double deflector positioned after the diaphragm for alignment of the charged particle beam along the optical axis may be included.

Further one of the following steps or a combination of the following steps may be applied for any of the methods. The measured value corresponding to the current passing through the aperture may be the current and/or the charge passing through the aperture. Alternatively or additionally, this value may be an indirect measurement result correlating to the current of the charged particle beam passing through the diaphragm, especially a detection signal of secondary electrons released on impingement of the charged particles on a solid body. Further, the charged particle beam may be focused with a gun lens. The emitter may be moved in a plane essentially perpendicular to an optical axis. The charged particle beam may be deflected within the gun lens and, additionally may be deflected with a component of the gun lens. Further, the charged particle beam having passed through the diaphragm may be aligned to an optical axis. The charged particle beam may be deflected within the gun lens and/or within a distance of about 30 mm or less from the emitter. The charged particles may be emitted by applying an extraction field between a field emitter and an extractor.

Having thus described the invention in detail, it should be apparent for a person skilled in the art that various modifications can be made in the present invention without departing from the scope of the following claims.

## Claims

1. A charged particle beam apparatus comprising:
an emitter (102) with an emission pattern including at least two emission peaks;
a gun lens (119 ; 519 ; 919); and
a diaphragm (120); **characterized in that**
the gun lens comprises a deflector unit (110); and wherein
the deflector unit is adapted to direct an emission peak of the at least two emission peaks to an opening of the diaphragm to thereby select the emission peak of the at least two emission peaks from the emission pattern.

2. Charged particle beam apparatus according to claim 1, wherein the deflector unit (110) is positioned within a distance of about 50 mm or less from the emitter.

3. Charged particle beam apparatus according to any of claims 1 to 2, wherein the gun lens is positioned within a distance of about 50 mm or less from the emitter (102).

4. Charged particle beam apparatus according to claim 1, wherein the deflector unit is positioned between the emitter and the gun lens.

5. Charged particle beam apparatus according to any of the preceding claims, wherein the deflector unit (110) is the middle electrode of the gun lens.

6. Charged particle beam apparatus according to any of the preceding claims, wherein the emitter is a field emitter.

7. Charged particle beam apparatus according to any of the preceding claims, wherein the diaphragm (120) is positioned after the deflector unit and adapted to have the plurality of emission areas to be scanned over the opening of the diaphragm by the deflector unit(110) .

8. Charged particle beam apparatus according to any of the preceding claims, wherein the diaphragm is integrated in the last electrode of the gun lens.

9. Charged particle beam apparatus according to any of the preceding claims, further comprising an extractor (104; 114) for extracting the charged particles from the emitter.

10. Charged particle beam apparatus according to claim 9, wherein the extractor is integrated in the gun lens.

11. Charged particle beam apparatus according to any of claims 9 to 10, wherein the extractor is adapted to form the first electrode of the gun lens.

12. Charged particle beam apparatus according to any of the preceding claims, wherein the deflector unit comprises a multipole element with at least three segments (111; 112; 113).

13. Charged particle beam apparatus according to claim 12, wherein the multipole element is a quadrupole element.

14. Charged particle beam apparatus according to claim 12, wherein the multipole element is an octupole element.

15. Charged particle beam apparatus according to any of claims 12 to 14, wherein the multipole element is adapted to form the middle electrode of the gun lens.

16. Charged particle beam apparatus according to any of the preceding claims, wherein the deflector unit is electrostatic.

17. Charged particle beam apparatus according to any of the preceding claims, wherein the gun lens (119; 519; 919) is electrostatic or combined electrostatic-magnetic.

18. Charged particle beam apparatus according to any of the preceding claims, further comprising a displacement unit (160) for mechanically shifting the emitter in a plane essentially orthogonal to the optical axis.

19. Charged particle beam apparatus according to any of the preceding claims, further comprising a detector (130; 134) for measuring the charged particle current passing through the diaphragm.

20. Charged particle beam apparatus according to claim 19, wherein the detector is a faraday-cup (130) positioned after the diaphragm.

21. Charged particle beam apparatus according to claim 19, wherein the detector (134) measures secondary electrons released from a specimen on impingement of the charged particles emitted by the emitter.

22. Charged particle beam apparatus according to any of the preceding claims, further comprising a double deflector (151, 152) positioned after the diaphragm for alignment of the charged particle beam along the optical axis.

23. Method for measuring an emission pattern of an emitter comprising the steps of
providing an emitter (102) with an emission pattern including at least two emission peaks; and
deflecting the emission pattern of the charged particle beam over an opening of a diaphragm (120);
focusing the charged particle beam with a gun lens, the gun lens comprising a deflector unit adapted to direct an emission peak of the at least two emission peaks to the opening of the diaphragm, thereby selecting the emission peak of the least two emission peaks from the emission pattern;
measuring a value correlated to the current passing through the diaphragm; and evaluating the value as a function of the deflection.

24. Method according to claim 23, wherein the value is the current and/or the charge passing through the diaphragm.

25. Method according to claim 23, wherein the value is an indirect measurement result correlated to the current of the charged particle beam passing through the diaphragm.

26. Method according to any of claims 23 or 25, wherein the value is a detection signal generated by secondary electrons released on impingement of the charged particles on a solid body.

27. Method according to any of claims 23 to 26, further comprising the step of moving the emitter (102) in a plane essentially perpendicular to an optical axis (101).

28. Method according to any of claims 23 to 27, wherein the charged particle beam is deflected within the gun lens.

29. Method according to any of claims 23 to 27, wherein the charged particle beam is deflected by a component of the gun lens.

30. Method of selecting an emission peak of an emission pattern comprising the steps of
providing an emission pattern obtained according to any of claims 23 to 27;
electing an emission peak of the emission pattern; and
deflecting the charged particle beam to allow the elected emission peak to pass through an opening of a diaphragm (120).

31. Method according to claim 30, further comprising the step of
focusing the charged particle beam by a gun lens.

32. Method according to any of claims 30 to 31, further comprising the step of:
moving the emitter in a plane essentially perpendicular to an optical axis (101).

33. Method according to any of claims 30 to 32 further comprising the step of:
aligning the charged particle beam having passed through the diaphragm to an optical axis.

34. Method according to any of claims 30 to 33, wherein the charged particle beam is deflected within the gun lens.

35. Method according to any of claims 30 to 34, wherein the charged particle beam is deflected by a component of the gun lens.

36. Method according to any of claims 30 to 35, wherein the charged particle beam is deflected within a distance of about 30 mm or less from the emitter.

37. Method according to any of claims 30 to 36, wherein the charged particles are emitted by applying an extraction field between a field emitter (102) and an extractor (104; 114).

38. Method according to any of claims 30 to 37, whereby the gun lens is operated to focus the charged particle beam on the specimen.

39. Method according to any of claims 30 to 37, whereby an objective lens is operated to focus the charged particle beam on the specimen.

40. A charged particle beam column comprising:
an apparatus according to any of claims 1 to 22; and
a specimen stage for holding a specimen.

41. The charged particle beam column according to claim 40, further comprising:
an objective lens for focusing the charged particle beam on the specimen.

## Patentansprüche

1. Vorrichtung für einen Strahl geladener Teilchen, welche umfasst:
einen Emitter (102) mit einem Emissionsmuster, das mindestens zwei Emissionsspitzen umfasst;
eine Linse des Strahlerzeugungssystems (119; 519; 919); und
ein Diaphragma (120);
**dadurch gekennzeichnet, dass**
die Linse des Strahlerzeugungssystems eine Ablenkeinheit (110) umfasst; und wobei die Ablenkeinheit eingerichtet ist, eine Emissionsspitze der mindestens zwei Emissionsspitzen auf eine Öffnung des Diaphragmas zu richten, um **dadurch** die Emissionsspitze der mindestens zwei Emissionsspitzen aus dem Emissionsmuster auszuwählen.

2. Vorrichtung für den Strahl geladener Teilchen nach Anspruch 1, wobei die Ablenkeinheit (110) innerhalb eines Abstands von ungefähr 50 mm oder weniger von dem Emitter positioniert ist.

3. Vorrichtung für den Strahl geladener Teilchen nach einem der Ansprüche 1 bis 2, wobei die Linse des Strahlerzeugungssystems innerhalb eines Abstands von ungefähr 50 mm oder weniger von dem Emitter (102) positioniert ist.

4. Vorrichtung für den Strahl geladener Teilchen nach Anspruch 1, wobei die Ablenkeinheit zwischen dem Emitter und der Linse des Strahlerzeugungssystems positioniert ist.

5. Vorrichtung für den Strahl geladener Teilchen nach einem der vorhergehenden Ansprüche, wobei die Ablenkeinheit (110) die Mittenelektrode der Linse des Strahlerzeugungssystems ist.

6. Vorrichtung für den Strahl geladener Teilchen nach einem der vorhergehenden Ansprüche, wobei der Emitter ein Feldemitter ist.

7. Vorrichtung für den Strahl geladener Teilchen nach einem der vorhergehenden Ansprüche, wobei das Diaphragma (120) nach der Ablenkeinheit positioniert und eingerichtet ist, die Vielzahl von Emissionsbereichen durch die Ablenkeinheit über die Öffnung des Diaphragmas scannen zu lassen.

8. Vorrichtung für den Strahl geladener Teilchen nach einem der vorhergehenden Ansprüche, wobei das Diaphragma in der letzten Elektrode der Linse des Strahlerzeugungssystems integriert ist.

9. Vorrichtung für den Strahl geladener Teilchen nach einem der vorhergehenden Ansprüche, welche weiter einen Extraktor umfasst zum Extrahieren der geladenen Teilchen aus dem Emitter.

10. Vorrichtung für den Strahl geladener Teilchen nach Anspruch 9, wobei der Extraktor in der Linse des Strahlerzeugungssystems integriert ist.

11. Vorrichtung für den Strahl geladener Teilchen nach einem der Ansprüche 9 bis 10, wobei der Extraktor eingerichtet ist, die erste Elektrode der Linse des Strahlerzeugungssystems zu bilden.

12. Vorrichtung für den Strahl geladener Teilchen nach einem der vorhergehenden Ansprüche, wobei die Ablenkeinheit ein Multipolelement mit mindestens drei Segmenten (111; 112; 113) umfasst.

13. Vorrichtung für den Strahl geladener Teilchen nach Anspruch 12, wobei das Multipolelement ein Quadrupolelement ist.

14. Vorrichtung für den Strahl geladener Teilchen nach Anspruch 12, wobei das Multipolelement ein Oktupolelement ist.

15. Vorrichtung für den Strahl geladener Teilchen nach einem der Ansprüche 12 bis 14, wobei das Multipolelement eingerichtet ist, die Mittenelektrode der Linse des Strahlerzeugungssystems zu bilden.

16. Vorrichtung für den Strahl geladener Teilchen nach einem der vorhergehenden Ansprüche, wobei die Ablenkeinheit elektrostatisch ist.

17. Vorrichtung für den Strahl geladener Teilchen nach einem der vorhergehenden Ansprüche, wobei die Linse des Strahlerzeugungssystems (119; 519; 919) elektrostatisch oder kombiniert elektrostatisch-magnetisch ist.

18. Vorrichtung für den Strahl geladener Teilchen nach einem der vorhergehenden Ansprüche, welche weiter eine Verschiebeeinheit (160) umfasst zum mechanischen Schieben des Emitters in einer Ebene im Wesentlichen orthogonal zu der optischen Achse.

19. Vorrichtung für den Strahl geladener Teilchen nach einem der vorhergehenden Ansprüche, welche weiter einen Detektor (130; 134) umfasst zum Messen des Stroms geladener Teilchen, der durch das Diaphragma tritt.

20. Vorrichtung für den Strahl geladener Teilchen nach Anspruch 19, wobei der Detektor ein Faradaybecher (130) ist, der nach dem Diaphragma positioniert ist.

21. Vorrichtung für den Strahl geladener Teilchen nach Anspruch 19, wobei der Detektor (134) sekundäre Elektronen misst, die von der Probe abgegeben werden beim Auftreffen der geladenen Teilchen, die von dem Emitter emittiert werden.

22. Vorrichtung für den Strahl geladener Teilchen nach einem der vorhergehenden Ansprüche, welche weiter einen Doppeldeflektor (151, 152) umfasst, der nach dem Diaphragma positioniert ist, zum Ausrichten des Strahls geladener Teilchen entlang der optischen Achse.

23. Verfahren zum Messen eines Emissionsmusters eines Emitters, wobei das Verfahren die Schritte umfasst:
Bereitstellen eines Emitters (102) mit einem Emissionsmuster, welches mindestens zwei Emissionsspitzen umfasst; und
Ablenken des Emissionsmusters des Strahls geladener Teilchen über eine Öffnung eines Diaphragmas (120);
Fokussieren des Strahls geladener Teilchen mit einer Linse des Strahlerzeugungssystems, wobei die Linse des Strahlerzeugungssystems eine Ablenkeinheit umfasst, die eingerichtet ist, eine Emissionsspitze der mindestens zwei Emissionsspitzen auf die Öffnung des Diaphragmas zu richten, um **dadurch** die Emissionsspitze der mindestens zwei Emissionsspitzen aus dem Emissionsmuster auszuwählen;
Messen eines Wertes, der mit dem Strom korreliert, der durch das Diaphragma tritt; und Auswerten des Werts als eine Funktion der Ablenkung.

24. Verfahren nach Anspruch 23, wobei der Wert der durch das Diaphragma tretende Strom und/oder die durch das Diaphragma tretende Ladung ist.

25. Verfahren nach Anspruch 23, wobei der Wert ein indirektes Messergebnis ist, das mit dem Strom des Strahls geladener Teilchen korreliert, der durch das Diaphragma tritt.

26. Verfahren nach einem der Ansprüche 23 oder 25, wobei der Wert ein Detektionssignal ist, das durch sekundäre Elektronen erzeugt wird, die beim Auftreffen der geladenen Teilchen auf einen Festkörper abgegeben werden.

27. Verfahren nach einem der Ansprüche 23 bis 26, welches weiter den Schritt umfasst:
Bewegen des Emitters (102) in einer Ebene, die im Wesentlichen senkrecht zu einer optischen Achse (101) ist.

28. Verfahren nach einem der Ansprüche 23 bis 27, wobei der Strahl geladener Teilchen innerhalb der Linse des Strahlerzeugungssystems abgelenkt wird.

29. Verfahren nach einem der Ansprüche 23 bis 27, wobei der Strahl geladener Teilchen durch eine Komponente der Linse des Strahlerzeugungssystems abgelenkt wird.

30. Verfahren zum Auswählen einer Emissionsspitze eines Emissionsmusters, wobei das Verfahren die Schritte umfasst:
Bereitstellen eines nach einem der Ansprüche 23 bis 27 erhaltenen Emissionsmusters;
Auswählen einer Emissionsspitze des Emissionsmusters; und
Ablenken des Strahls geladener Teilchen, um der ausgewählten Emissionsspitze zu erlauben, durch eine Öffnung eines Diaphragmas (120) zu treten.

31. Verfahren nach Anspruch 30, welches weiter den Schritt umfasst:
Fokussieren des Strahls geladener Teilchen durch eine Linse des Strahlerzeugungssystems.

32. Verfahren nach einem der Ansprüche 30 bis 31, welches weiter den Schritt umfasst:
Bewegen des Emitters in einer Ebene, die im Wesentlichen senkrecht zu einer optischen Achse (101) ist.

33. Verfahren nach einem der Ansprüche 30 bis 32, welches weiter den Schritt umfasst:
Ausrichten des Strahls geladener Teilchen, der durch das Diaphragma getreten ist, an einer optischen Achse.

34. Verfahren nach einem der Ansprüche 30 bis 33, wobei der Strahl geladener Teilchen innerhalb der Linse des Strahlerzeugungssystems abgelenkt wird.

35. Verfahren nach einem der Ansprüche 30 bis 34, wobei der Strahl geladener Teilchen durch eine Komponente der Linse des Strahlerzeugungssystems abgelenkt wird.

36. Verfahren nach einem der Ansprüche 30 bis 35, wobei der Strahl geladener Teilchen innerhalb eines Abstands zum Emitter von ungefähr 30 mm oder weniger abgelenkt wird.

37. Verfahren nach einem der Ansprüche 30 bis 36, wobei die geladenen Teilchen emittiert werden, indem ein Extraktionsfeld zwischen einem Feldemitter (102) und einem Extraktor (104; 114) angelegt wird.

38. Verfahren nach einem der Ansprüche 30 bis 37, wobei die Linse des Strahlerzeugungssystems betrieben wird, um den Strahl geladener Teilchen auf die Probe zu fokussieren.

39. Verfahren nach einem der Ansprüche 30 bis 37, wobei eine Objektivlinse betrieben wird, um den Strahl geladener Teilchen auf die Probe zu fokussieren.

40. Eine Säule für einen Strahl geladener Teilchen, welche umfasst:
eine Vorrichtung gemäß einem der Ansprüche 1 bis 22; und
einen Probenhalter zum Halten der Probe.

41. Die Säule für den Strahl geladener Teilchen nach Anspruch 40, welche weiter umfasst:
eine Objektivlinse zum Fokussieren des Strahls geladener Teilchen auf die Probe.

## Revendications

1. Appareil à faisceau de particules chargées comprenant :
un émetteur (102) ayant un modèle d'émission incluant au moins deux pics d'émission ;
une lentille de canon (119;519;919); et
un diaphragme (120) :
**caractérisé en ce que**
la lentille de canon comprend une unité de déviation (110) ; et **en ce que**
l'unité de déviation est adaptée à diriger un pic d'émission parmi lesdits au moins deux pics d'émission vers une ouverture du diaphragme pour, ainsi, sélectionner le pic d'émission parmi lesdits au moins deux pics d'émission du modèle d'émission.

2. Appareil à faisceau de particules chargées selon la revendication 1, dans lequel l'unité de déviation (110) est positionnée au sein d'une distance d'environ 50 mm ou moins à partir de l'émetteur.

3. Appareil à faisceau de particules chargées selon l'une quelconque des revendications 1 ou 2, dans lequel la lentille de canon est positionnée au sein d'une distance d'environ 50 mm ou moins à partir de l'émetteur.

4. Appareil à faisceau de particules chargées selon la revendication 1, dans lequel l'unité de déviation est positionnée entre l'émetteur et la lentille de canon.

5. Appareil à faisceau de particules chargées selon l'une quelconque des revendications précédentes, dans lequel l'unité de déviation (110) est l'électrode médiane de la lentille de canon.

6. Appareil à faisceau de particules chargées selon l'une quelconque des revendications précédentes, dans lequel l'émetteur est un émetteur de champ.

7. Appareil à faisceau de particules chargées selon l'une quelconque des revendications précédentes, dans lequel le diaphragme (120) est positionné après l'unité de déviation et adapté à ce que la pluralité de zones d'émission balayent l'ouverture du diaphragme, sous l'action de l'unité de déviation (110).

8. Appareil à faisceau de particules chargées selon l'une quelconque des revendications précédentes, dans lequel le diaphragme est intégré dans la dernière électrode de la lentille de canon.

9. Appareil à faisceau de particules chargées selon l'une quelconque des revendications précédentes, comprenant, en outre, un extracteur (104;114) pour extraire les particules chargées de l'émetteur.

10. Appareil à faisceau de particules chargées selon la revendication 9, dans lequel l'extracteur est intégré dans la lentille de canon.

11. Appareil à faisceau de particules chargées selon l'une quelconque des revendications 9 et 10, dans lequel l'extracteur est adapté à former la première électrode de la lentille de canon.

12. Appareil à faisceau de particules chargées selon l'une quelconque des revendications précédentes, dans lequel l'unité de déviation (110) comprend un élément multipôle ayant au moins trois segments (111;112;113).

13. Appareil à faisceau de particules chargées selon la revendication 12, dans lequel l'élément multipôle est un élément quadrupôle.

14. Appareil à faisceau de particules chargées selon la revendication 12, dans lequel l'élément multipôle est un élément octupôle.

15. Appareil à faisceau de particules chargées selon l'une quelconque des revendications 12 à 14, dans lequel l'élément multipôle est adapté à former l'électrode médiane de la lentille de canon.

16. Appareil à faisceau de particules chargées selon l'une quelconque des revendications précédentes, dans lequel l'unité de déviation est électrostatique.

17. Appareil à faisceau de particules chargées selon l'une quelconque des revendications précédentes, dans lequel la lentille de canon (119;519;919) est électrostatique ou électrostatique-magnétique combinée.

18. Appareil à faisceau de particules chargées selon l'une quelconque des revendications précédentes, comprenant, en outre, une unité de déplacement (160) pour faire passer mécaniquement l'émetteur dans un plan essentiellement orthogonal à l'axe optique.

19. Appareil à faisceau de particules chargées selon l'une quelconque des revendications précédentes, comprenant, en outre, un détecteur (130;134) pour mesurer le courant de particules chargées passant au travers du diaphragme.

20. Appareil à faisceau de particules chargées selon la revendication 19, dans lequel le détecteur est un collecteur de Faraday (130) positionné après le diaphragme.

21. Appareil à faisceau de particules chargées selon la revendication 19, dans lequel le détecteur (134) mesure des électrons secondaires libérés depuis un spécimen lors de l'impact des particules chargées émises par l'émetteur.

22. Appareil à faisceau de particules chargées selon l'une quelconque des revendications précédentes, comprenant, en outre, un double déflecteur (151,152) positionné après le diaphragme pour l'alignement du faisceau de particules chargées avec l'axe optique.

23. Procédé de mesure d'un modèle d'émission d'un émetteur, comprenant les étapes suivantes :
la fourniture d'un émetteur (102) ayant un modèle d'émission incluant au moins deux pics d'émission ; et
la déviation du modèle d'émission du faisceau de particules chargées sur une ouverture d'un diaphragme (120) ;
la concentration du faisceau de particules chargées au moyen d'une lentille de canon, la lentille de canon comprenant une unité de déviation adaptée à diriger un pic d'émission parmi lesdits au moins deux pics d'émission vers l'ouverture du diaphragme pour, ainsi, sélectionner le pic d'émission parmi lesdits au moins deux pics d'émission du modèle d'émission ;
la mesure d'une valeur corrélée au courant passant au travers du diaphragme ; et
l'évaluation de la valeur en fonction de la déviation.

24. Procédé selon la revendication 23, dans lequel la valeur est le courant et/ou la charge passant au travers du diaphragme.

25. Procédé selon la revendication 23, dans lequel la valeur est un résultat de mesure indirecte corrélé au courant du faisceau de particules chargées passant au travers du diaphragme.

26. Procédé selon l'une quelconque des revendications 23 ou 25, dans lequel la valeur est un signal de détection généré par des électrons secondaires libérés depuis un corps solide lors de l'impact, sur celui-ci, des particules chargées.

27. Procédé selon l'une quelconque des revendications 23 à 26, comprenant, en outre, l'étape de déplacement de l'émetteur (102) dans un plan essentiellement perpendiculaire à un axe optique (101).

28. Procédé selon l'une quelconque des revendications 23 à 27, dans lequel le faisceau de particules chargées est dévié au sein de la lentille de canon.

29. Procédé selon l'une quelconque des revendications 23 à 27, dans lequel le faisceau de particules chargées est dévié par un composant de la lentille de canon.

30. Procédé de sélection d'un pic d'émission d'un modèle d'émission, comprenant les étapes suivantes :
la fourniture d'un modèle d'émission obtenu selon l'une quelconque des revendications 23 à 27 ;
le choix d'un pic d'émission du modèle d'émission ; et
la déviation du faisceau de particules chargées pour permettre au pic d'émission choisi de passer au travers d'une ouverture d'un diaphragme (120).

31. Procédé selon la revendication 30, comprenant, en outre, l'étape de :
concentration du faisceau de particules chargées par une lentille de canon.

32. Procédé selon l'une quelconque des revendications 30 et 31, comprenant, en outre, l'étape de :
déplacement de l'émetteur dans un plan essentiellement perpendiculaire à un axe optique (101).

33. Procédé selon l'une quelconque des revendications 30 à 32, comprenant, en outre, l'étape de :
alignement, avec un axe optique, du faisceau de particules chargées qui a passé au travers du diaphragme.

34. Procédé selon l'une quelconque des revendications 30 à 33, dans lequel le faisceau de particules chargées est dévié au sein de la lentille de canon.

35. Procédé selon l'une quelconque des revendications 30 à 34, dans lequel le faisceau de particules chargées est dévié par un composant de la lentille de canon.

36. Procédé selon l'une quelconque des revendications 30 à 35, dans lequel le faisceau de particules chargées est dévié au sein d'une distance d'environ 30 mm ou moins à partir de l'émetteur.

37. Procédé selon l'une quelconque des revendications 30 à 36, dans lequel les particules chargées sont émises en appliquant un champ d'extraction entre un émetteur de champ (102) et un extracteur (104; 114).

38. Procédé selon l'une quelconque des revendications 30 à 37, dans lequel la lentille de canon est activée pour concentrer le faisceau de particules chargées sur le spécimen.

39. Procédé selon l'une quelconque des revendications 30 à 37, dans lequel une lentille d'objectif est activée pour concentrer le faisceau de particules chargées sur le spécimen.

40. Colonne à faisceau de particules chargées comprenant :
un appareil selon l'une quelconque des revendications 1 à 22 ; et
une platine à spécimen pour porter un spécimen.

41. Colonne à faisceau de particules chargées selon la revendication 40, comprenant, en outre :
une lentille d'objectif pour concentrer le faisceau de particules chargées sur le spécimen.
